Europäisches Patentamt

European Patent Office

Office européen des brevets

(19)

(11) Publication number: **0 232 184 B1**

(12) **EUROPEAN PATENT SPECIFICATION**

(45) Date of publication of patent specification: **23.12.92** (51) Int. Cl.⁵: **H01L 31/02**

(21) Application number: **87301053.2**

(22) Date of filing: **06.02.87**

(54) **Infrared detector.**

(30) Priority: **07.02.86 JP 25019/86**

(43) Date of publication of application:
**12.08.87 Bulletin 87/33**

(45) Publication of the grant of the patent:
**23.12.92 Bulletin 92/52**

(84) Designated Contracting States:
**DE FR GB**

(56) References cited:
**EP-A- 0 063 694**
**EP-A- 0 191 682**
**US-A- 3 963 926**

**PATENT ABSTRACTS OF JAPAN, vol. 10, no. 42 (E-382)[2099], 19th February 1986 & JP-A-60 198 774 (FUJITSU K.K.) 08-10-1985**

(73) Proprietor: **FUJITSU LIMITED**
**1015, Kamikodanaka Nakahara-ku**
**Kawasaki-shi Kanagawa 211(JP)**

(72) Inventor: **Maekawa, Tohru**
**2-12-5, Shinjo Nakahara-ku**
**Kawasaki-shi Kanagawa 211(JP)**
Inventor: **Ueda, Satoshi**
**Sanhaitsu-Shimizu 202 1263, Tomuro**
**Atsugi-shi Kanagawa 243(JP)**
Inventor: **Takigawa, Hiroshi**
**2-9-13, Shinjo Nakahara-ku**
**Kawasaki-shi Kanagawa 211(JP)**
Inventor: **Kochi, Tetsuya**
**Otani-apart., 6843, Okazaki**
**Isehara-shi Kanagawa 259-11(JP)**
Inventor: **Goto, Junjiro**
**3-3-29, Iho**
**Takasago-shi Hyogo 676(JP)**

(74) Representative: **Billington, Lawrence Emlyn et al**
**HASELTINE LAKE & CO Hazlitt House 28**
**Southampton Buildings Chancery Lane**
**London WC2A 1AT(GB)**

## Description

The present invention relates to an infrared detector, more particularly, it relates to a structure of a cold shield for an infrared detector array.

Infrared images are detected by an infrared detector of an imaging system. The infrared detector comprises an infrared detector array and an infrared shielding device, which absorbs infrared radiation (below, "infrared") and is fully cooled so that the shielding device does not become an infrared emitting source. Since the infrared shielding device is cooled, it is known as a cold shield.

The cold shield excludes unnecessary and undesired infrared, and necessary and desired infrared to be detected is allowed to pass through the cold shield, whereby the infrared image to be detected is accurately detected by the detector array. Conventionally, however, infrared reflected by an electrode of a detector element in an array is reflected by optical parts and then sometimes impinges on the detecting area. Thus, the detection accuracy for the infrared is lowered. This phenomenon is known as optical crosstalk.

JP-A-60 198774 by the present applicant discloses an infrared ray detector having the features of the preamble of accompanying claim 1.

According to the present invention, there is provided an infrared detector comprising:-

a cold shield having one or more first and one or more second portions located adjacent one another, the or each first portion being a light shielding portion comprising a substrate made of an infrared transmitting material and an infrared absorbing layer formed on one side surface of the substrate; and the or each second portion being an opening portion comprising said substrate; and

an infrared detector array having a detecting area arranged facing the or each opening portion of said cold shield;

characterised in that:-

the or each first portion consists of an infrared absorbing layer, of a dielectric layer made of an infrared transmitting material, and of an infrared reflecting layer formed on the dielectric layer; and the or each second portion is a region of said dielectric layer and formed on said surface of the substrate; wherein the following expressions are satisfied:-

$$n3 = \sqrt{n1} \text{ and } n3 \times d1 = \lambda/4,$$

wherein $\lambda$ is the wavelength of infrared radiation to be detected, $n1$ is the refractive index of said substrate, $n3$ is the refractive index of said dielectric layer and $d1$ is the thickness of said dielectric layer.

An embodiment of the present invention may provide an infrared detector of an imaging system wherein an infrared image can be accurately detected.

An embodiment of the present invention may provide an infrared detector having a cold shield wherein infrared rays absorbed in the cold shield are not emitted therefrom.

Further, an embodiment of the present invention may provide an infrared detector having openings in a cold shield, through which openings only necessary and desired infrared rays are allowed to pass.

Reference is made, by way of example, to the accompanying drawings in which:

Fig.1 is a schematic cross-sectional view of a previously proposed infrared detector;

Fig.2 is a partially enlarged cross-sectional view of Fig.1;

Fig.3 is a schematic cross-sectional view of an embodiment of the present invention;

Fig.4 is a cross-sectional view of a cold shield of Fig.3;

Fig.5 is a plan view of a cold shield provided on a detector array; and

Fig.6 is a cross-sectional view taken along a line A-A' of Fig.5.

Before describing the present invention the related art will be explained in detail.

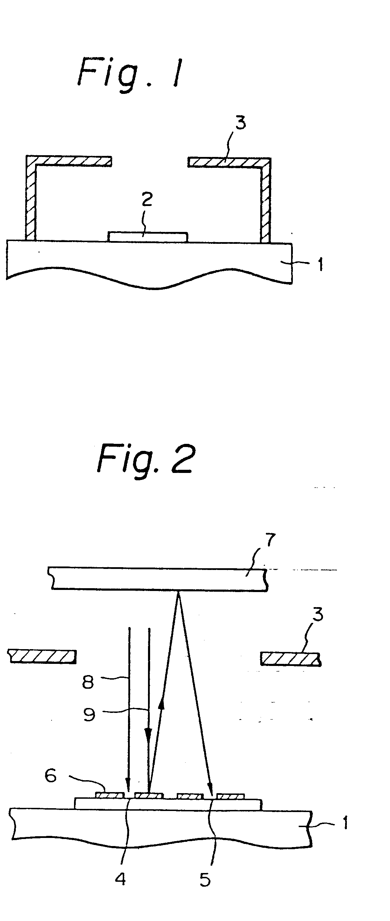

Figure 1 is a schematic cross-sectional view of a previously proposed infrared detector, and as shown in Fig.1, an infrared detector array 2, which detects an infrared image, is provided on a cold stage 1 which is cooled by, for example, liquid nitrogen. Further, a cold shield 3 is also provided on the cold stage 1 so that unnecessary and undesired infrared rays are shielded, and necessary and desired infrared rays are passed therethrough to lead the infrared to detector array 2.

The cold shield 3 is made of aluminium having, for example, a black surface. The cold shield 3 absorbs the infrared (infrared radiation) and is fully cooled by a cooling device (not shown) at the cold stage 1 so that the cold shield 3 does not become an infrared emitting source.

Thus, the cold shield 3 excludes unnecessary and undesired infrared. On the other hand, by leading only infrared passed through an opening of the cold shield to the detector array, an accurate detection of the infrared image is obtained.

As shown in Fig.2, infrared rays 8 directly impinge on a detective (detecting) area 4, and infrared rays allowed to impinge on the detector array 2 through a window 7 are detected by the detective area 4. However, infrared rays 9 impinging on the electrodes 6 are reflected by the electrodes 6 so that the reflected infrared rays are reflected by the window 7, etc., and often impinge on, for example, another detective area 5, whereby the accuracy of the infrared detection is lowered.

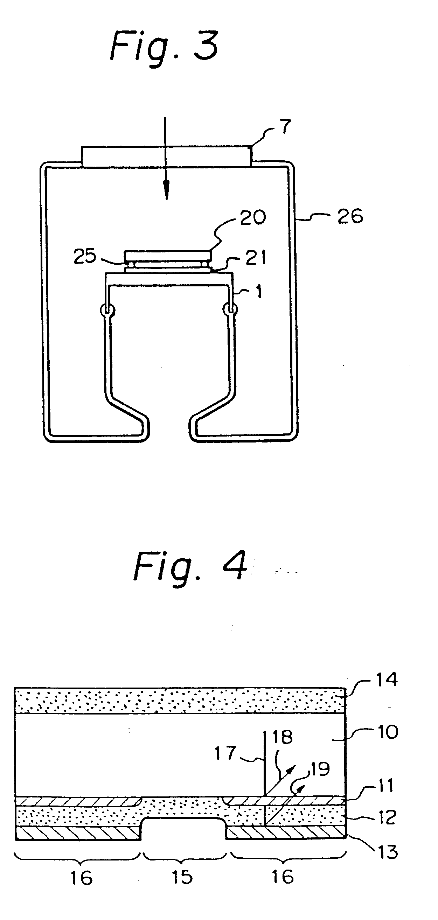

Figure 3 shows a schematic cross-sectional view of an embodiment of the present invention.

As shown in Fig.3, an infrared detector comprising a cold shield 20 and infrared detector array 21 is provided on the cold stage 1, and spacers 25 are arranged between the cold shield and the infrared detector array 21. A window 7, through which infrared rays are allowed to pass to impinge on the infrared detector, is set in a dewar 26 and faces the infrared detector.

The cold shield portion shown in Fig.3 will be explained with reference to Fig.4.

A light (i.e. infrared) shielding portion 16 of the cold shield consists of five layers; i.e. a dielectric layer 14, a substrate 10, an infrared absorbing layer 11 formed on one surface of the substrate 10, a dielectric layer 12 formed on the infrared absorbing layer 11, and an infrared reflecting layer 13 formed on the dielectric layer 12. The substrate 10 is made of an infrared penetrating (transmitting) material, for example, ZnS, ZnSe, and Ge, etc., and the infrared absorbing layer 11 is made of, for example, Cr or Ni, etc. The dielectric layer is made of, for example, $CeF_3$ or $PbF_2$ etc. The infrared reflecting layer 13 is made of a metal such as Al or Au, etc.

The light shielding portion 16 of the cold shield efficiently eliminates infrared rays by absorbing them and causing destructive interference when they impinge on the portion 16.

The present invention is effective even without the dielectric layer 14.

An opening portion (transmitting portion) 15 of the cold shield consists of three layers, i.e. the dielectric layer 14, the substrate 10, and the dielectric layer 12.

Infrared rays impinging thereon from above are efficiently passed through the opening portion 15 of the cold shield, so that they are led to a detective area (not shown).

The effects of this embodiment of the present invention will be explained.

Since the opening portion 15 of the cold shield is formed by the substrate 10 made of an infrared transmitting material and the dielectric layer 12, which have a proper refractive index for giving a good optical transmission property, the infrared rays impinging on the opening portion 15 can be efficiently led to a detective area.

The wavelength of the infrared impinging on the opening portion is assumed to be λ, and the refractive indices of the substrate 10 and the dielectric layers 12 and 14 are assumed to be n1 and n3, respectively. Further, the thickness of each dielectric layer is assumed to be d1. As is well known, when the expressions $n3 = \sqrt{n1}$ and $n3 \times d1 = \lambda/4$ are satisfied, the optimum transmittance is realised. Therefore, most of the infrared impinging on an opening portion passes through the opening portion of a structure satisfying such conditions and reaches a detective area.

Then, part of the infrared 17 impinging on the light shielding portion 16 is reflected at the interface between the substrate 10 and the infrared absorbing layer 11, due to the difference between the refractive indices n1 and n2 thereof. The part of the infrared reflected at the interface is designated 18 in Fig.4.

Part of the remaining infrared, not reflected at the interface, is absorbed in the infrared absorbing layer 11 and the remainder passes through into the dielectric layer 12 to reach the infrared reflecting layer 13.

This infrared reflected at the surface of the infrared reflecting layer 13 passes through the dielectric layer 12 again and is partly absorbed by the infrared absorbing layer 11, the rest being emitted from the infrared absorbing layer 11. The emitted infrared is designated 19.

By equalising the intensity of the infrared 18 and 19, and at the same time reversing the phases therebetween, the infrared 18 and 19 are mutually cancelled and thus the emission of infrared from the light shielding portion 16 is prevented.

The regulation of the intensity of the infrared 18 and 19 can be carried out by selecting the material and the thickness of the infrared absorbing layer 11. Further, regulation of the phase difference between the infrared 18 and 19 can be carried out by adjusting of the thickness of the dielectric layer 12.

In particular, when relationships n1 < n2, n3 < n4 or n1 > n2, n3 > n4 exist among refractive indices n1, n2, n3 and n4 of the substrate 10, the absorbing layer 11, the dielectric layer 12, and the reflecting layer 13 respectively, both phase reversal of infrared impinging on the infrared absorbing layer 11, and that of infrared impinging on the infrared reflecting layer 13, occur in the former condition, and neither phase reversal occurs in the latter condition. Thus, the thickness of the dielectric layer 12, which gives rise to phase reversal between infrared 18 and 19, corresponds to the layer thickness d1 ($n3 \times d1 = \lambda/4$) having the optimum transmittance determined at the above-mentioned opening portion 15 of the cold shield. Thus, since the thickness of the dielectric layers in the opening portion and the light receiving portion 16 may be made the same thickness, the cold shield can be produced advantageously.

When infrared having a wavelength of 10 μm is detected, a dielectric layer of about 1.7 μm, which is calculated from the expression $n3 \times d1 = \lambda/4$, is used to give the optimum infrared cancelling condition. In this case, for example, a substrate 10 of ZnS having a thickness of 200 to 500 $\mu$m, an absorbing layer of Cr having a thickness of about 0.05 $\mu$m, and an absorbing layer 13 of Al having a thickness of about 1 $\mu$m, are used.

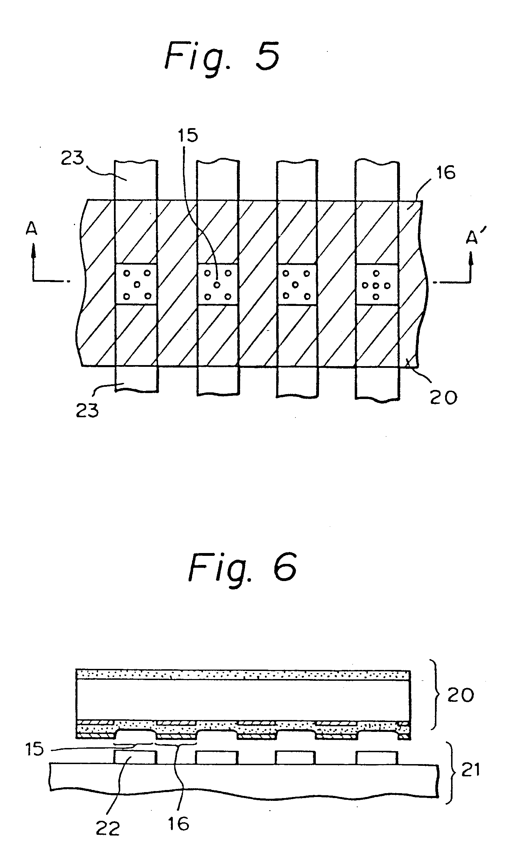

Figure 5 shows a plan view of a cold shield provided on a detector array embodying the present invention, and Figure 6 shows a cross-sectional view taken along a line A-A' of Fig.5.

As shown in Fig.5, the light shielding portion 16 of the cold shield 20 shields all portions except for the detective area 22. The opening portion 15 of the cold shield 20 is provided just above the detective area 22. Thus, infrared impinging on the opening portion 15 is led only to the detective area 22 just below the opening portion 15. On the other hand, since infrared impinging on the light shielding portion 16 is eliminated by the absorbing effect and interference action of the light shielding portion 16, the problem of undesired infrared reaching another detective area because of reflection at the electrode-23, etc., as explained for the related art, does not occur.

## Claims

1. An infrared detector comprising:-

    a cold shield (20) having one or more first and one or more second portions (15, 16) located adjacent one another, the or each first portion being a light shielding portion (16) comprising a substrate (10) made of an infrared transmitting material and an infrared absorbing layer (11) formed on one side surface of the substrate; and the or each second portion being an opening portion (15) comprising said substrate (10); and

    an infrared detector array (21) having a detecting area (22) arranged facing the or each opening portion (15) of said cold shield (20);

    characterised in that:-

    the or each first portion (16) consists of an infrared absorbing layer (11), of a dielectric layer (12) made of an infrared transmitting material, and of an infrared reflecting layer (13) formed on the dielectric layer (12); and the or each second portion (15) is a region of said dielectric layer (12) and formed on said surface of the substrate (10); wherein the following expressions are satisfied:-

    $$n3 = \sqrt{n1} \text{ and } n3 \times d1 = \lambda/4,$$

    wherein $\lambda$ is the wavelength of infrared radiation to be detected, n1 is the refractive index of said substrate (10), n3 is the refractive index of said dielectric layer (12) and d1 is the thickness of said dielectric layer (12).

2. An infrared detector according to claim 1, wherein a further dielectric layer (14) is formed on the surface of said substrate (10) opposite to that on which the infrared absorbing layer (11), the dielectric layer (12) and the infrared reflecting layer (13) are formed.

3. An infrared detector according to claim 1 or 2, wherein the refractive index for infrared radiation of the dielectric layers (12, 14) is smaller than the refractive index of the substrate (10), and at the same time larger than 1.

4. An infrared detector according to claim 1, 2 or 3, wherein the infrared absorbing layer (11) consists of Cr or Ni.

5. An infrared detector according to any preceding claim, wherein the dielectric layers (12, 14) consist of $CeF_3$ or $PbF_2$.

6. An infrared detector according to any preceding claim, wherein infrared rays reflected at the infrared absorbing layer (11) and infrared rays reflected at the infrared reflecting layer (13) are mutually cancelled by destructive interference.

## Patentansprüche

1. Infrarotdetektor, enthaltend:

    einen kalten Schirm (20), der einen oder mehrere erste und einen oder mehrere zweite nebeneinander angeordnete Teile (15, 16) hat, wobei der oder jeder erste Teil ein Licht abschirmender Teil (16) ist, der ein aus einem für Infrarot durchlässigem Material hergestelltes Substrat (10) und eine Infrarot absorbierende Schicht (11) enthält, die auf einer seitlichen Oberfläche des Substrats gebildet ist; und wobei der oder jeder zweite Teil ein das genannte Substrat (10) enthaltender Öffnungs-Teil (15) ist; und

    eine Infrarotdetektor-Anordnung (21) mit einer detektierenden Fläche (22), die dem oder jedem Öffnungs-Teil (15) des benannten kalten Schirms (20) gegenüberliegend angeordnet ist;

    dadurch gekennzeichnet, daß:

    der oder jeder erste Teil (16) aus einer Infrarot absorbierenden Schicht (11), einer aus für Infrarot durchlässigem Material hergestellten dielektrischen Schicht (12) und aus einer auf der dielektrischen Schicht (12) gebildeten Infrarot reflektierenden Schicht (13) besteht; und daß der oder jeder zweite Teil (15) ein Bereich der genannten dielektrischen Schicht (12) ist und auf der genannten Oberfläche des Substrats (10) geformt ist; wobei die folgenden Gleichungen erfüllt sind:

$$n3 = \sqrt{n1} \text{ und } n3 \times d1 = \lambda/4,$$

wobei $\lambda$ die Wellenlänge der zu detektierenden Infrarotstrahlung, n1 der Brechungsindex des genannten Substrats (10), n3 der Brechungsindex der genannten dielektrischen Schicht (12) und dl die Dicke der genannten dielektrischen Schicht (12) ist.

2. Infrarotdetektor nach Anspruch 1, bei dem eine weitere dielektrische Schicht (14) auf derjenigen Oberfläche des genannten Substrats (10) gebildet ist, die der Oberfläche gegenüberliegt, auf der die Infrarot absorbierende Schicht (11), die dielektrische Schicht (12) und die Infrarot reflektierende Schicht (13) gebildet sind.

3. Infrarotdetektor nach Anspruch 1 oder 2, bei dem der für Infrarotstrahlung geltende Brechungsindex der dielektrischen Schichten (12, 14) kleiner ist als der Brechungsindex des Substrats (10) und gleichzeitig größer als 1.

4. Infrarotdetektor nach Anspruch 1, 2 oder 3, bei dem eine Infrarot absorbierende Schicht (11) aus Cr oder Ni besteht.

5. Infrarotdetektor nach einem der vorstehenden Ansprüche, bei dem die dielektrischen Schichten (12, 14) aus $CeF_3$ oder $PbF_2$ bestehen.

6. Infrarotdetektor nach einem der vorstehenden Ansprüche, bei dem an der Infrarot absorbierenden Schicht (11) reflektierte Infrarotstrahlen und an der Infrarot reflektierenden Schicht (13) reflektierte Infrarotstrahlen durch destruktive Interferenz gegenseitig ausgelöscht werden.

**Revendications**

1. Détecteur à infrarouge comprenant :
   un écran froid (20) ayant une ou plusieurs premières et une ou plusieurs secondes parties (15, 16) disposées adjacentes les unes aux autres, la ou chaque première partie étant une partie formant écran à la lumière (16) comprenant un substrat (10) fait d'une matière transmettant l'infrarouge et d'une couche absorbant l'infrarouge (11) formée sur l'une des faces du substrat ; et la ou chaque seconde partie étant une partie ouverture (15) comprenant ledit substrat (10) ; et
   un réseau détecteur à infrarouge (21) ayant une surface détectrice (22) disposée en face de la, ou de chaque, partie ouverture (15) dudit écran froid (20) ;
   caractérisé en ce que :
   la, ou chaque, première partie (16) est constituée d'une couche absorbant l'infrarouge (11), d'une couche diélectrique (12) faite d'une matière transmettant l'infrarouge, et d'une couche réfléchissant l'infrarouge (13) formée sur la couche diélectrique (12) ; et en ce que la, ou chaque, seconde partie (15) est une région de ladite couche diélectrique (12) et en ce qu'elle est formée sur ladite surface du substrat (10) ; et en ce que les expressions suivantes sont satisfaites :

$$n3 = \sqrt{n1} \text{ et } n3 \times d1 = \lambda/4,$$

dans laquelle $\lambda$ est la longueur d'onde de la radiation infrarouge à détecter, n1 est l'indice de réfraction dudit substrat (10), n3 est l'indice de réfraction de ladite couche diélectrique (12) et d1 est l'épaisseur de ladite couche diélectrique (12).

2. Détecteur à infrarouge selon la revendication 1, dans lequel une couche diélectrique supplémentaire (14) est formée sur la face dudit substrat (10) opposée à celle sur laquelle la couche absorbant l'infrarouge (11), la couche diélectrique (12) et la couche réfléchissant l'infrarouge (13) sont formées.

3. Détecteur à infrarouge selon la revendication 1 ou 2, dans lequel l'indice de réfraction pour la radiation infrarouge des couches diélectriques (12, 14) est plus petit que l'indice de réfraction du substrat (10), et en même temps plus grand que 1.

4. Détecteur à infrarouge selon la revendication 1, 2 ou 3, dans lequel la couche absorbant l'infrarouge (11) est constituée de Cr ou de Ni.

5. Détecteur à infrarouge selon l'une quelconque des revendications précédentes, dans lequel les couches diélectriques (12, 14) sont constituées de $CeF_3$ ou de $PbF_2$.

6. Détecteur à infrarouge selon l'une quelconque des revendications précédentes, dans lequel les rayons infrarouges réfléchis au droit de la couche absorbant l'infrarouge (11) et les rayons infrarouges réfléchis au droit de la couche réfléchissant l'infrarouge (13) s'annulent mutuellement par interférence destructrice.

# Fig. 1

# Fig. 2

## Fig. 3

## Fig. 4

**EP 0 232 184 B1**

## Fig. 5

## Fig. 6

8